# EUROPEAN PATENT SPECIFICATION

(11) **EP 2 911 300 B1**
(45) Date of publication and mention of the grant of the patent: **12.05.2021**
(21) Application number: 14305241.3
(22) Date of filing: 21.02.2014
(51) Int. Cl.: H03K 17/96, H01H 13/50, H03K 17/965

(54) **Touch sensitive electrical control device with a haptic feedback**
Berührungsempfindliche elektrische Steuerungsvorrichtung mit haptischer Rückmeldung
Dispositif de commande électrique tactile à retour haptique

(43) Date of publication of application: 26.08.2015
(73) Proprietor: Berker GmbH & Co. KG, 58579 Schalksmühle (DE)
(72) Inventor: Gruszeninks, Johann, 76476 Bischweier (DE); Rapp, Marc, 76187 Karlsruhe (DE); Mollitor, Jens, 77656 Offenburg (DE)
(74) Representative: Cabinet Nuss

(56) References cited:
- EP-A1- 2 026 178
- EP-A1- 2 330 485
- EP-A1- 2 372 915
- WO-A2-2005/019987
- WO-A2-2010/026515
- US-A1- 2011 122 072

## Description

The present invention relates to electrical control devices, in particular for a domestic electrical installation and concerns more specifically an electrical device, such as a switch for example, which is touch sensitive and has a haptic feedback.

A wall mounted electrical control device is connected in an electrical information house network and can have different purposes: work as a doorphone communication device, and/or as a home automation control device, exchanging information with a central control about temperature, light, shading, security and alarms, etc. Such a device is at least able to send different electrical signals, in line with the wishes and intentions of the user. These signals are based on low currents, typically used in electrical information networks. Such an electrical control device usually comprises at least one handle, plate or similar actuating member, which can be touched by the user, or even moved or displaced. Such a handle normally moves as a single piece.

In this field, EP0899763 discloses a control device for sending a plurality of different instructions. The device has three parallel moving handles, and a pair of microswitches for each handle. Each microswitch is provided under an end of a handle, making the device able to send two instructions per handle, corresponding to the actuation of one of the two microswitches, when the handle is pressed at one end or at the other. The main problem in such a design is that a single electrical control device has a plurality of moving handles, thereby complicating the design and assembly, especially for devices which should send numerous different instructions. Manufacturing tolerances also have more impact on the clearance between the handles and the guiding thereof, which can lead to a device looking like a product of poor quality.

DE102004035321 discloses a switch with a single handle, and four microswitches provided under said handle. The handle is mounted in the support so as to be able to actuate each microswitch individually. Therefore, it is possible to have four different signals with a single handle, depending on the movement created by the user and on the corresponding actuated microswitch. A similar working principle is disclosed in DE29917382, with a single handle and four movable contacts, each provided approximately under a corner of the rectangular handle. However, such a working principle can hardly be extended to more than four instructions per rectangular handle, as a good detection of the different corresponding actions can be quite difficult. Reliability is also an issue, because the movement of the handle can actuate more than one microswitch at a time, leading to the erroneous simultaneous generation of more than one instruction.

In order to solve this issue, touch sensitive controls can be used, like in DE10110759. In this prior art, a flat user interface is decomposed in two control areas, each having a touch sensitive surface. A flat plate covers the touch sensitive elements and forms a fixed control handle. DE19847225, or even DE20226017603, proposes a similar embodiment, using a single continuous touch sensitive surface. Different predefined zones of the single surface are virtually associated with different instructions. However, the problem is that erroneous instructions can be generated, if the user touches the surface in an undesired zone.

DE102006048546 discloses an electrical switch with a handle provided with a plurality of touch sensitive elements. A microswitch is integrated under the handle and generates a confirmation signal. The signals sent by the touch sensitive surfaces and the signal sent by the microswitch are combined by a microprocessor to generate an instruction. One of the main problems of this working principle is that some movements of the handle might not trigger the single microswitch, especially for a large sized handle. Furthermore, due to possible bending of a large sized handle, the mechanical feedback is not homogeneous.

EP 2 372 915 A1 discloses a human machine interface for automobile vehicles. The human machine interface is configured for controlling the air condition, the audio system, the communication system or the navigation system of an automobile vehicle. The human machine interface comprises a touch detection means configured to be displaced between a proximal and a distal position and a control system generating a haptic effect during the displacement of the touch detection means. The control system further detects said distal position in order to validate a control selected on a selection area of the touch detection means.

EP 2 330 485 A1 discloses an input unit for portable electronic devices such as cellular phones, music players, gaming devices and electronic dictionaries for instance. The input unit comprises a display means, and input panel, a detection means and a control means. The detection means is a switch which detects an applied status of pressing force to the input surface of the input panel. In one embodiment, the input unit comprises four switches.

WO 2005/019987 A2 discloses a touchpad for handheld devices like personal digital assistants. The touchpad comprises a capacitive sensing means used for moving an input pointer on a display screen. The touchpad further has the function of a depressible button for performing one or more mechanical clicking actions. Thereby, the touchpad can be configured to actuate one or more movement indicators, which are capable of generating a button signal, when the touchpad is moved to a depressed position.

The main objective of the present invention is to improve this state of the art as mentioned, and to have an electrical control device of a robust design and with which a single moving handle thereof can generate many different instructions in a reliable and possible intuitive way, corresponding to the wishes and intentions of the user.

According to the invention, the above and possibly other objectives are attained by an electrical control device according to independent claim 1.

These and other objects, features and advantages of the present invention will become more apparent from the following description when taken in connection with the accompanying drawings which show, for purposes of illustration only, some embodiments in accordance with the present invention:
- figure 1 shows an electrical control device in the shape of a wall mounted switch, with two separate handles;
- figures 1A and 1B are schematic drawings of a movement detector according to two alternative embodiments, namely a normaly openend configuration (figure 1A) and a normaly closed configuration (figure 1B);
- figure 2 is a partial view showing details of a movement detector in the closed state of a device according to an embodiment of the invention;
- figure 3 is a partial view showing more details of the same movement detector in the open state;
- figure 4 is a partial view focusing on the snap dome of the feedback unit shown on figure 3;
- figures 4A to 4C illustrate schematically three successive positions and corresponding states of a movement detector as shown on figures 2 to 4;
- figure 5 is a partial view showing another embodiment of the device according to the invention with a normally open detection circuit and a pair of microswitches for the feedback unit;
- figure 6 shows the contact of a movement detector shown in figure 5 in the closed state;
- figure 7 focuses on the interaction between the handle and a microswitch along with an alternative embodiment;
- figure 8 is a symbolic representation showing the electric layout for a normally closed movement detection circuit;
- figure 9 is a symbolic representation showing the electric layout for a normally open movement detection circuit;
- figure 9A is a schematic drawing a possible electric layout of another embodiment of a movement detection circuit;
- figure 10 is a cross section of a battery powered embodiment;
- figure 11 shows an embodiment of the inventive device with a single handle and three microswitches;
- figure 12 shows a movement sensing unit in the shape of a set of three microswitches, and
- figure 13 is a cross section of the embodiment shown in figure 12.

The scope of the invention is defined in the appended claims. Any reference to "embodiment(s)", "example(s)" or "aspect(s) of the invention" in this description not falling under the scope of the claims should be interpreted as illustrative example(s) for understanding the invention. The invention mainly consists in an electrical control device 1 for generating and sending different instruction or/and behavior signals.

Said device 1 mainly comprises:
- a movable handle 2, for the interaction with the user and having a plurality (at least two) of separate instruction zones;
- a movement sensing unit 4, for detecting the movement of the handle 2 when it is actuated by the user;
- a touch sensing unit 5, for detecting touches (i.e. a low pressure physical contact by the user, without actual actuation of the handle) on the handle 2 and locations thereof;
- a feedback unit 6, for creating a tactile feedback or haptic function when the handle 2 is moved;
- a control unit 13, which receives input signals from the movement sensing unit 4 as well as input signals from the touch sensing unit 5 and which generates said instruction and/or behavior signals accordingly.

Said device 1 is normaly wall mounted, either on the surface of a wall or at least partially embedded in said wall.

The handle 2 can be pivoting on a support 3 and have three or more different instruction zones. Preferably, the control unit 13 is made of a single microprocessor, or even two microprocessors. The touch sensing unit 5 can be a continuous touch sensitive surface or a plurality of separate touch sensitive elements or detectors 5a. These units will be further described later. The handle moves as a single piece, normaly made of plastic. It is preferably a single piece of plastic material.

The device 1 can of course also comprise two or more handles 2, each with its associated units 4, 5 and 6.

The device 1 can also comprise means for sending signals (luminous, sound, ...) to the outside environment and intended for the user.

According to the invention, the movement sensing unit 4 is made of a set of at least two separate movement detectors 4a, each able to detect the movement of the handle 2. These movement detectors 4a are preferably separately connected to the control unit 13 for sending to the latter a signal corresponding to a movement of the handle 2. Using a plurality of spread movement detectors 4a helps in correctly detecting the movement of the handle 2, which would be difficult to detect with a single detector and a large handle 2.

Because of this, and in particular of the duplication and redundancy of the movement detectors 4a, the electrical control device of the invention shows a better reactivity and a greater liability than similar existing devices.

Preferably, the feedback unit 6 differs from the set of movement detectors 4a forming the movement sensing unit 4. Thus, the means used for the feedback unit 6 and the means used for movement sensing unit 4 are different, these units being preferably separate and independent units. Nevertheless, the feedback unit 6 and the movement sensing unit 4 may have some common elements. But, even in this case, at least one unit should have some elements which are not used by the other unit. This helps in the robust detection of the movement and generation of the feedback.

As will be further described later on, according to another possible additional feature, the movement sensing unit 4 comprises at least one conductivity based movement detector 4a, comprising a movable contact which is moved by the handle 2 to open or close a corresponding electric circuit.

In one embodiment of the invention, the electrical control device 1 is a house switch to be wall mounted, preferably in a flush manner. Such an electrical control device 1 is dedicated to be fixed on a mounting element, like a box or a metallic and flat base. It has a surrounding frame 11, defining a central opening through which a user can interact with the electrical mechanism of the device 1.

The electrical control device 1 may work as a control device in an information network, like a house automation network, and be able to send different instructions or signals. It can comprise a single, two or more handles 2, i.e. at least one.

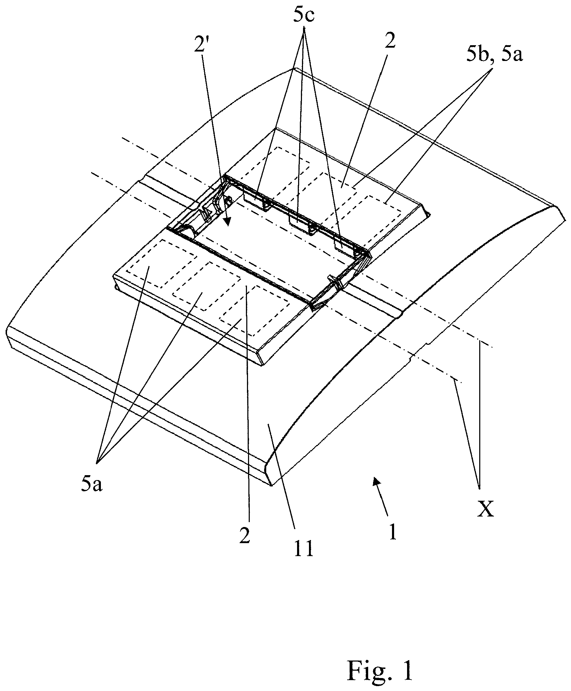

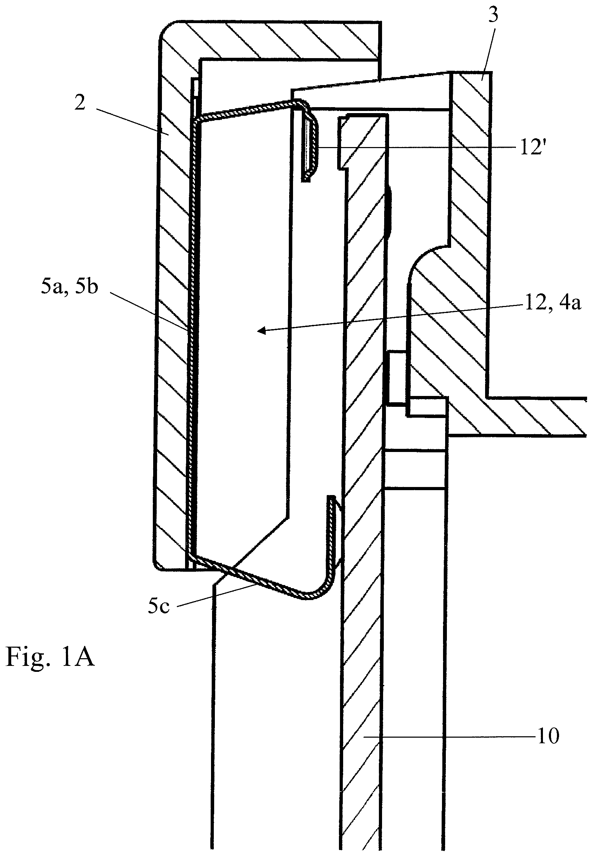

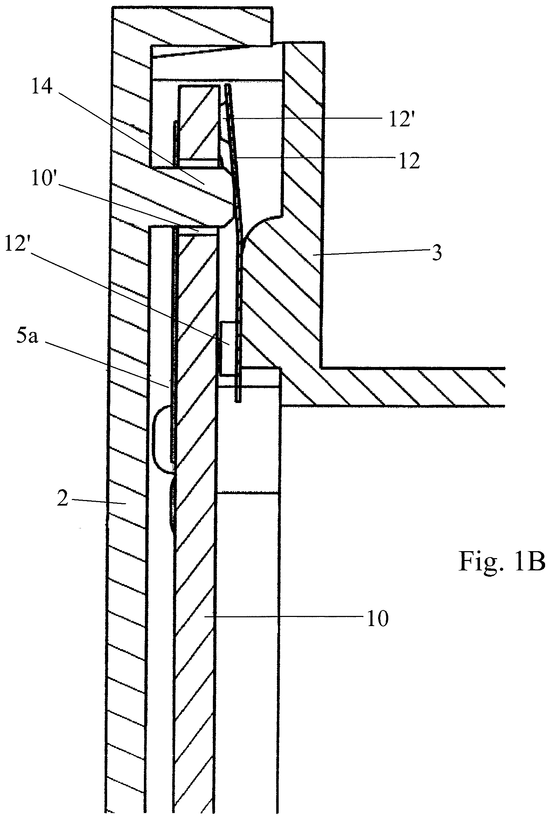

As shown figure 1, the electrical control device 1 may have two parallel handles 2, facing each other. Each handle 2 can be rotated around an axis which is parallel to the wall the device is mounted on. The two rotation axes X are preferably parallel and located approximately at the level of parallel sides of a central rectangular separation area 2', located between the two handles 2 and inside the frame 11.

Three touch control zones (each being associated to a touch detector 5a) are associated with each handle 2, for detecting touches of the user at the external surface thereof. Therefore, three different instructions can be generated by the device 1 when the user touches the handle 2, depending on the exact location of the touch on the handle 2. If the user presses the handle 2 and moves it, other instructions can be generated by the device 1, for example three other instructions, depending on the exact location of the simultaneous touch on the handle 2. A single instruction can also be associated with the movement of the handle 2, whatever the exact location of the finger(s) on the handle 2. Different combinations are possible for the control unit 13 while taking the signals into account for generating an instruction.

The movement of each handle 2 is detected by a corresponding movement sensing unit 4, located under the handle 2, and which comprises a set of movement detectors 4a, preferably at least three.

According to a possible feature, the touch sensing unit 5 is made of a set of at least two separate touch detectors 5a, each connected to the control unit 13 for sending to the latter a signal corresponding to a touch in a corresponding predefined area of the handle 2, preferably capacitive based touch detectors 5a, for example one touch detector 5a per control or function allocated zone on the handle 2, or even two triangular and complementary touch detectors 5a.

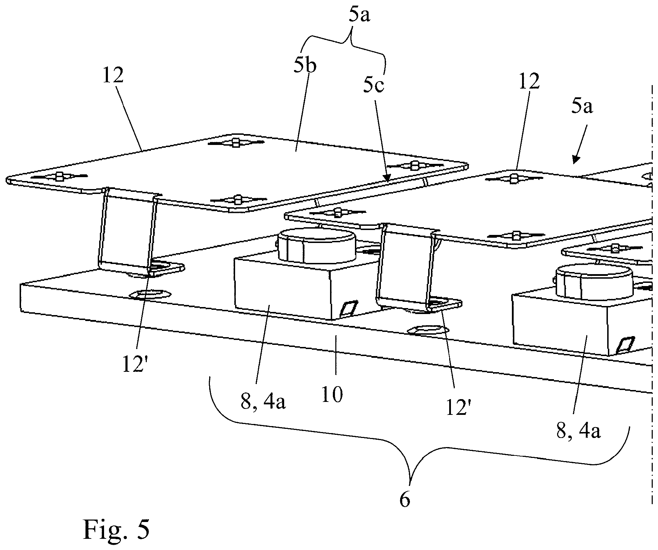

For the device 1 of figure 1, the touches on each handle 2 are detected by a touch sensing unit 5 provided under each handle 2, in the form of three capacitive based touch detectors 5a (see also figure 5). Each touch detector 5a sends its own signal to the control unit 13, which makes it possible to identify three different touch locations on the handle 2. The control unit 13 is preferably a microprocessor, and each touch detector 5a is connected to an entry of said microprocessor.

A feedback unit 6 is also provided for giving back to the user a different feeling between a touch on the handle 2 and a movement of the handle 2. This haptic function can be achieved with different working principles. The feedback unit 6 can be a mechanical element opposing a resistance to the movement of the handle 2, like a spring, or even a so-called microswitch. A known standard microswitch can produce such a mechanical resistance opposed to its actuation. The feedback unit 6 can also use sound, light, or vibrations, generated only if the handle 2 is pressed. Another function of the feedback unit 6 can be to bring the handle 2 back in its normal position. A spring, or microswitch, serves both function: giving a different feeling and bringing the handle 2 back.

Preferably, the feedback unit 6 is made of separate force generators, preferably one or two, the design of which will be detailed later. These mechanical element push the handle 2 back in its normal position.

The control unit 13 is preferably made of a single microprocessor, separately receiving signals from each touch detector 5a. The microprocessor 13 also receives signals from the movement sensing unit 4, either from each movement detector 4a separately or from the movement sensing unit 4 as a whole, connected to a single processor entry. The number of connection lines between the microprocessor 13 and the movement sensing unit 4 is comprised between one, for layouts in which a single signal is received from the whole movement sensing unit 4, and the number of movement detectors 4a, for layouts in which each movement detector 4a is separately connected to the microprocessor.

Figures 1B, 2 and 3 provide partial detailed views of an embodiment for a movement detector 4a, working in a normally closed circuit. From a general standpoint, and according to another possible additional feature, the at least one conductivity based movement detector 4a, and preferably each movement detector 4a, is such that its corresponding electrical circuit is and remains closed as long as the handle is not moved by the user. Such a movement detector 4a uses a deformable contact bridge 12. The control device 1 has a printed circuit board 10 located under the handle 2. Metallic tracks on the bottom face of the printed circuit board 10 form an open circuit of a movement detector 4a. The contact bridge 12, also located at the bottom face of the printed circuit board 10, has two corresponding contact pads 12'. In the normal position, when the handle 2 is not pushed, the pads 12' of the contact bridge 12 touch the tracks and close the corresponding detector circuit. The current flows from one pad to the other through the contact bridge 12 and a corresponding signal is received by the microprocessor. When the handle 2 is pushed, the contact bridge 12 is deformed and an offset appears between the contact pads 12' and the metallic tracks. The corresponding movement detector circuit is opened and the signal received by the microprocessor is changed.

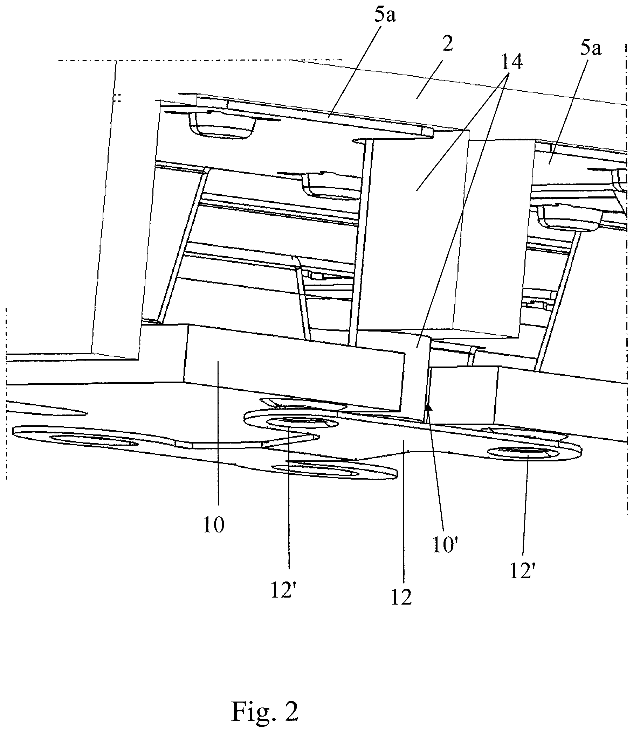

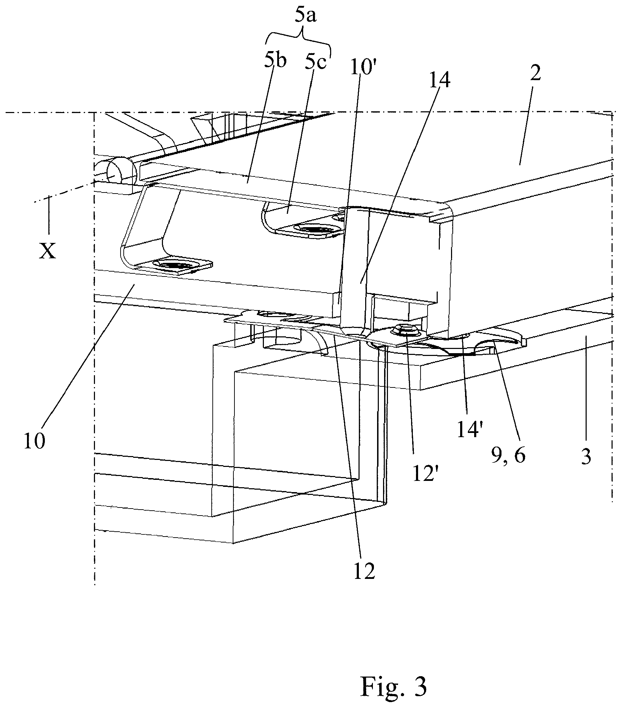

A pin 14 extends from the rear side of the handle 2, in the direction of the printed circuit board 10. When the handle 2 is moved, the pin 14 deforms the contact bridge 12 as described, resulting in opening the movement detector circuit. Figures 2 and 3 show that the printed circuit board 10 has an opening through which the pin 14 can touch the contact bridge 12 to deform it when the handle 2 is pressed.

Such a design of the movement detector 4a corresponds to a normally closed electrical detection circuit: the corresponding detection circuit is closed when the handle 2 is not pressed, and is open when the handle is pressed. Here, the tracks on the printed circuit board 10 are between the contact bridge 12 and the handle 2. As the movement of the handle 2 separates the contact bridge 12 from the printed circuit board 10, there is no risk to break the printed circuit board if the handle 2 is pressed with an excessive force or is moved with an excessive amplitude.

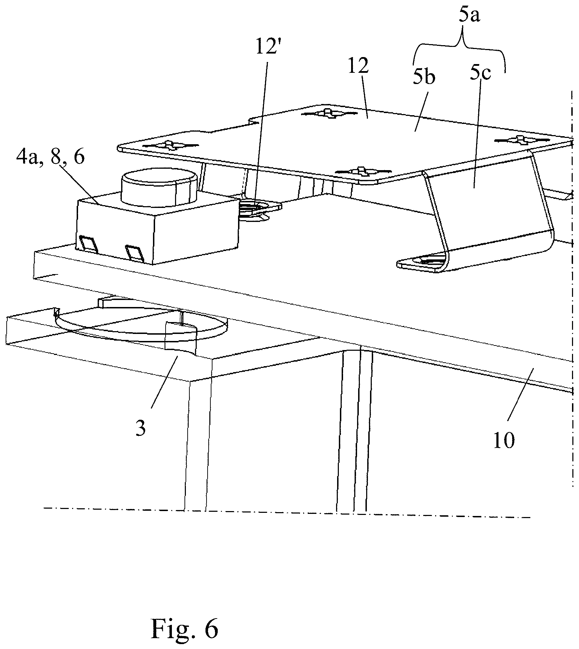

Figures 1A, 5, 6 and 7 show another embodiment of the movement detector 4a, corresponding to a normally open electric circuit: when the handle 2 is not pressed, the electrical detection circuit is open. From a general standpoint, and according to another possible additional feature, the at least one conductivity based movement detector 4a, and preferably each movement detector 4a, is such that its corresponding electrical circuit is open when the handle is not moved by the user. The circuit is closed when the handle 2 is moved. Therefore, an electric signal is brought to the microprocessor only when the handle 2 is moved enough to close the electrical circuit.

Here again, the movement detector 4a comprises a contact bridge 12. However, in this embodiment, the contact bridge 12 is located between the handle 2 and the tracks on the printed circuit board 10. When the handle 2 is pressed, it directly deforms or moves the contact bridge 12. If the handle 2 is moved enough, the contact bridge 12 touches, by means of pads 12' located at the end portions of a wing part for example, tracks on the printed circuit board 10, thereby closing the corresponding electrical circuit and sending an electrical signal to the microprocessor 13.

The embodiment of figures 5, 6 and 7 also differs from the embodiment of figures 2 and 3 in that each contact bridge 12 has only one contact pad 12'. An end of the contact bridge 12 is anchored to the printed circuit board 10, and electrically connected to the track of the detection circuit on said printed circuit board 10. The other end has the contact pad 12' which touches the other track when the handle 2 is pressed. Therefore, when the electric circuit is closed, the current flows in the contact bridge 12 from said end, connected to the track, to the opposite end, where the pad 12' is located.

A normally open movement detector 4a can also be based on a microswitch 8, triggered when the handle 2 is pushed enough. However, the mechanical resistance of such a microswitch 8 should be as limited as possible, and preferably null. Such a microswitch 8 would therefore only work for its electrical function, with no or approximately no mechanical resistance, thereby having no interference with the functions of the feedback unit 6.

The movement detectors 4a of the movement sensing unit 4 can each be connected to a separate entry of the microprocessor 13. In some other layouts, a single entry of the processor can be dedicated to the whole movement sensing unit 4. The movement detectors 4a can then be connected serialy or in parallel, depending on their normal electrical state, either open or closed.

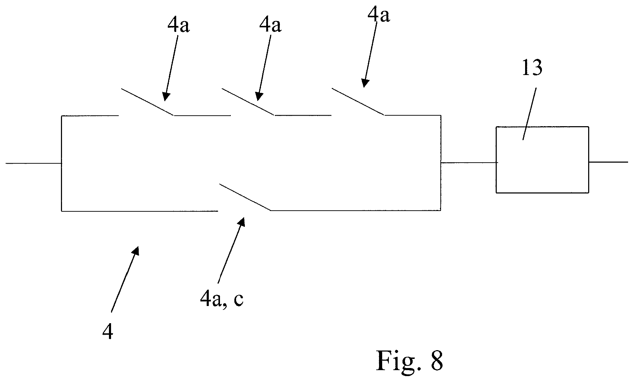

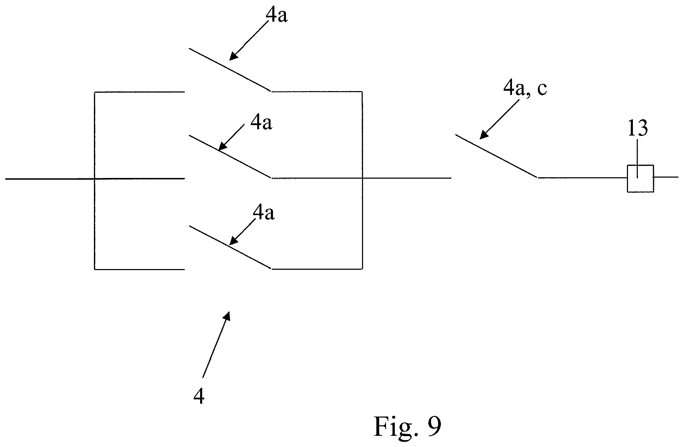

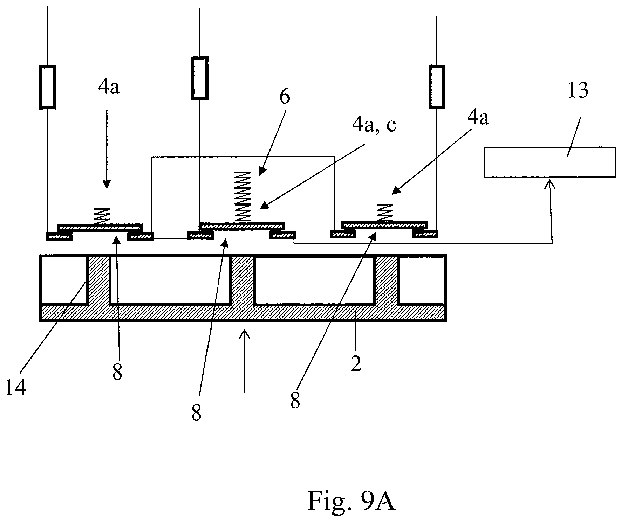

Two other possible electrical layouts for the movement detectors 4a are illustrated in figures 8 and 9.

Figure 8 is a possible connection layout for four normally closed movement detectors 4a with a contact bridge 12 as described in relation with the figures 1B, 2 and 3. The figure corresponds to the situation where the handle 2 is pushed enough to open each movement detector 4a. This movement detection circuit has two electrically parallel lines, finaly connected to the same entry of the control unit 13. One movement detector 4a, working as a confirmation switch 4a,c, is connected alone in one of these two lines. The three others normally closed movement detectors 4a are connected in series in the other line. If an electrical signal is received, the control unit concludes that the handle 2 has not been moved (i.e. is in its normal or resting position). If no electrical signal is received, the control unit concludes that the handle 2 has been moved. Therefore, in order to stop the signal flowing to the control unit, it is necessary to move the handle 2 enough to actuate the movement detector 4a working as a confirmation switch (single detector 4a,c in one branch), and at least one of the other movement detectors 4a. It is clear from the circuit shown in figure 8 that, if the confirmation switch 4a,c is open, the signal will be interrupted even if only some of the movement detectors 4a are open.

Figure 9 shows another movement detection circuit based on normally open movement detectors 4a. With such a circuit, the control unit 13 needs an electrical current to conclude that the handle 2 has been moved. The absence of electrical signal is interpreted as the handle 2 being in its normal or resting position. As shown in figure 9, the detection circuit has a normally open movement detector 4a working as a confirmation switch 4a,c, serialy connected to another switch unit. This switch unit 4 is made of three movement detectors 4a connected in parallel. The line is finally connected to the microprocessor 13. Therefore, the signal is received by the control unit 13 if the confirmation switch 4a,c is closed and if at least one of the other movement detectors 4a is closed.

Preferably, the movement detector 4a working as a confirmation switch 4a,c is located near the mechanical force generator of the feedback unit 6.

As shown in figure 9A, the means forming the haptic feedback unit 6 and the means forming the confirmation switch 4a,c can be arranged so as to be closed together. These two means can be either different separate means or consist in a single material component fulfilling both functions.

In some embodiments non illustrated, the movement sensing unit 4 is based on a capacitive principle: the movement of the handle 2 has an effect on capacity magnitude, which can be detected by the control unit 13. Preferably, the movement sensing unit 4 comprises at least one capacitive movement detector 4a made of a first metallic element mounted in the handle 2 and of a second metallic element mounted on a support 3 of the handle 2. The variation of the distance separating the first and second metallic elements leads to a variation of the capacity between them, allowing to detect whether the handle 2 is in its resting or actuated position.

The figures show also different possible embodiments for the feedback unit 6. According to a possible additional feature, the feedback unit 6 is made of at least one force generator, opposed to the movement of the handle 2, like a single mechanical spring or a single microswitch, preferably one or two. A force generator can be in the form of an elastic means with different possible designs.

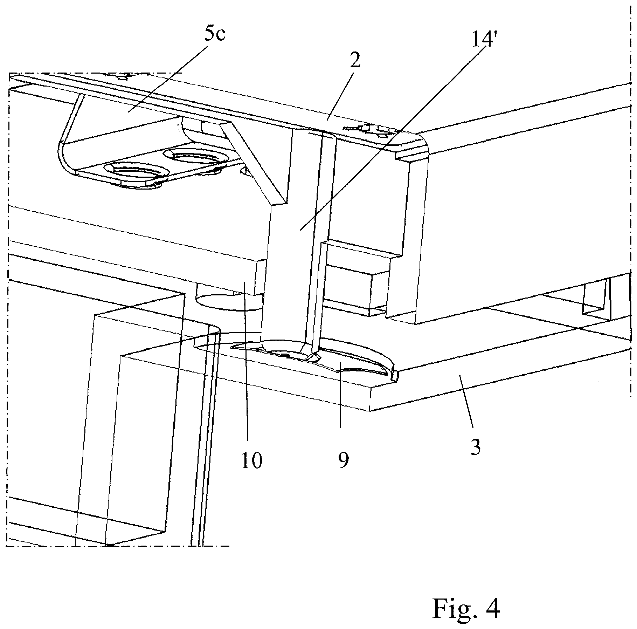

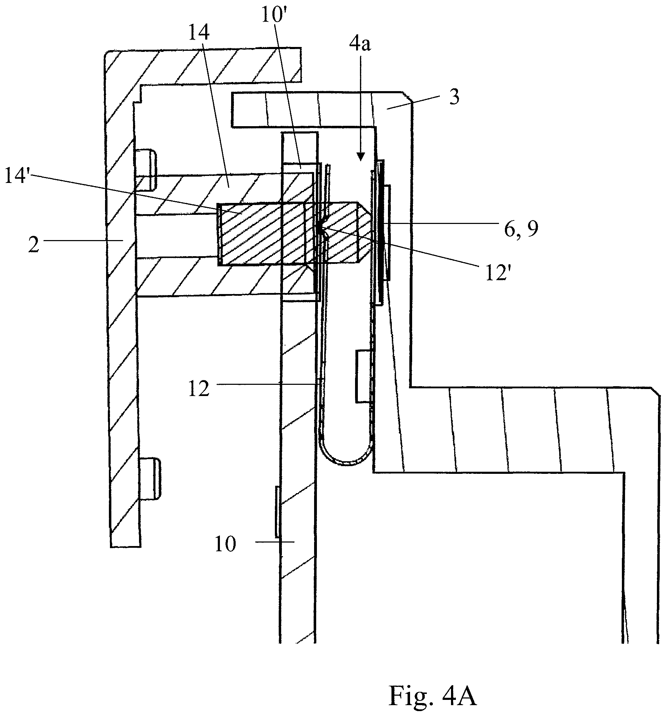

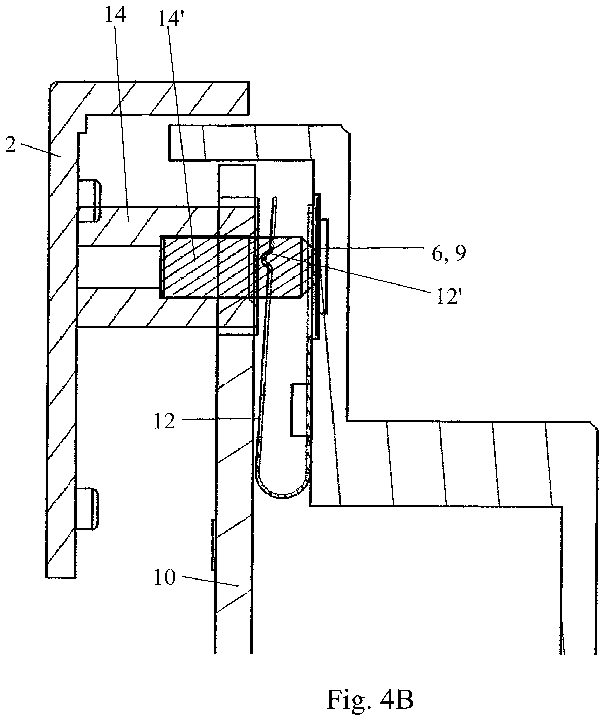

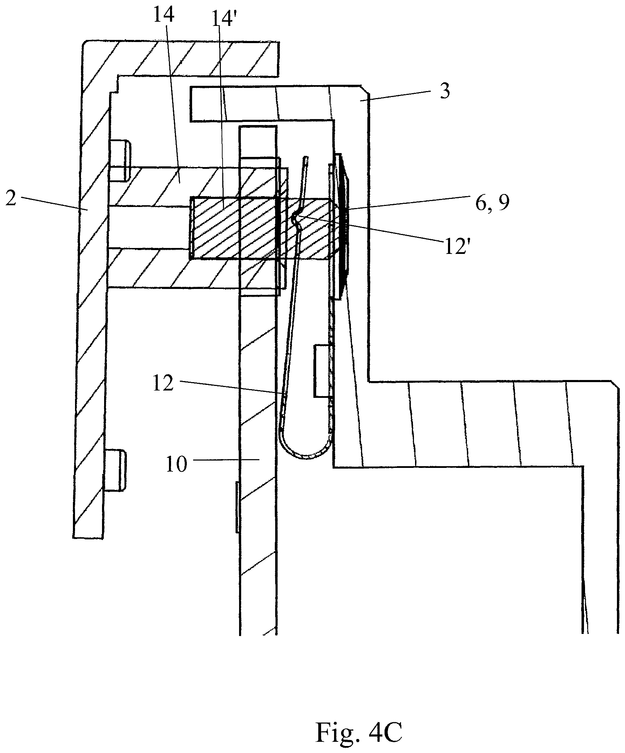

In some embodiments, the feedback unit 6 comprises at least one mechanical elastic dome 9, deformed when the handle 2 is moved by the user and which can act to push the handle 2 back to its normal position. The dome or each dome 9 is preferably a so-called tactile or snap dome. Figures 3 and 4 show such an elastic dome 9. This dome 9 is located under the handle 2, and elastically deformed when the handle 2 is pressed, thanks to a pin 14 extending from the rear side of the handle 2. Two domes 9 are preferably provided for each handle 2. This force generator can be located on the printed circuit board 10, between the printed circuit board 10 and the handle 2, or even under the printed circuit board like in figure 4. Figure 4 shows that the elastic dome 9 can rather be provided behind the printed circuit board 10, so that the latter is between the elastic dome 9 and the handle 2. A corresponding cut-out can then be provided in the printed circuit board 10 for the actuating pin 14'. The advantage of an elastic dome comes from its mechanical behaviour, which is more reliably identified as a confirmation by the user. While constantly increasing the deformation of the elastic dome, the corresponding force also increases until it reaches a maximum value, then it decreases again. Comparatively, for a classical spring, the force would keep increasing.

As shown on figure 3 or 4, the feedback unit 6 for a handle 2 can be formed by one elastic dome 9 or even a pair. They generate a force opposed to the movement of the handle 2, and can bring the handle 2 back in its normal position.

Figures 4A to 4C illustrate the successive states and positions of the constitutive components of a movement detector 4a (of the normaly closed type) associated with a dome 9 forming the feedback unit 6, a practical embodiment of such a detector being shown on figures 2 to 4.

In figure 4A the rocker pin 14, which is part of a handle 2, is in its normal or resting position, the switch being closed and the snap dome 9 not impacted. When the pin 14 is moved downwards, by actuation of the handle 2, it contacts the dome 9 and starts compressing it, the switch still remaining closed in the intermediate position illustrated in figure 4B.

In figure 4C, the pin 14 has further moved down and compresses substantially the dome 9, the switch being now open and thus a movement detection signal being delivered.

According to another possible feature, the feedback unit 6 can comprise at least one microswitch 8, actuated when the handle is moved by the user and which can act to push the handle 2 back to its normal position. Figures 5, 6 and 7 show such an alternative embodiment for the elastic means of the feedback unit 6, in the shape of a standard microswitch 8. As they are widely used, such microswitches 8 can provide a well known feedback feeling for the user. When the user presses the handle 2 and feels the resistance of a microswitch 8 or hears its sound, he or she directly interprets this as a confirmation or at least as a feedback. As best seen from figure 5, two microswitches 8 can be provided under each handle 2, and each microswitch 8 is located between two movement detectors 4a.

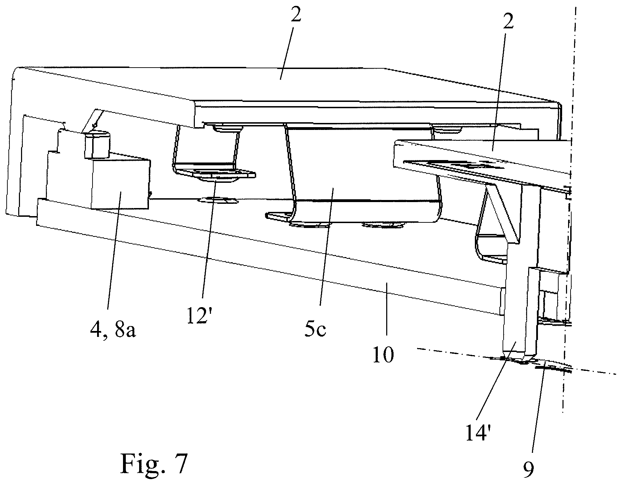

Figure 7 shows that a pin is provided behind the back surface of the handle 2, for pressing the microswitch 8.

The microswitch 8 can be used only for its mechanical and acoustical behaviour in the feedback unit 6, and would therefore be unconnected to the microprocessor. In alternative embodiments, the electrical function of the microswitch 8 is also used, and the latter is connected to the microprocessor 13, therefore also working as a movement detector 4a. According to a general possible feature, the at least one microswitch 8 also works as one of the movement detectors 4a of the movement sensing unit 4 and is connected to the control unit 13 to send a signal corresponding to its actuated state. When actuated, it usually sends an electrical signal to the microprocessor. Of course, in embodiments using more than one microswitch 8 for each handle 2, it is possible to connect only some of said microswitches 8 rather than each of them.

Hence, a microswitch 8 connected to the control unit 13 works as an element of the feedback unit 6 and also as a movement detector 4a. The electrical control device 1 can have a movement sensing unit 4 which comprises at least two movement detectors 4a in the form of contact bridges 12, and also at least one microswitch 8, used as a movement detector 4a but also part of the feedback unit 6.

Different working principles can be used for the touch sensing unit 5. The touch sensing unit 5 should at least be able to identify the location of a touch on the handle 2.

A single touch sensitive element could be used for the touch sensing unit 5, sending to the control unit 13 a single signal corresponding to the location of the touch. For example, a single capacitive or resistive surface can be used. The touch sensing unit 5 could also use an optical principle, for example by spreading light parallel to a surface of the handle 2 and measuring the interference created by a finger. A single signal is sent to the control unit, depending on the area of the handle 2 which is touched. Then, the control unit 13 takes into account a predefined set of virtual control zones on the handle 2, compares this set with the received touch location signal, identifies which of these zones is associated with the location of the touch, and behaves accordingly.

According to another additional possible feature, the touch sensing unit 5 can be made of a set of at least two separate capacitive based touch detectors 5a, each comprising a pair of metallic electrodes, provided on a printed circuit board 10 located under the handle 2, preferably on the support 3. Therefore, it is possible to use a touch sensing unit 5 made of a plurality of touch detectors 5a, using more than one entry of the control unit 13, preferably one entry for each touch detector 5a. For example, detecting the position of a touch along a certain axis can be achieved with a pair of capacitive cells. These two capacitive cells have complementary triangular shapes, and build together a rectangle, corresponding to the complete detection zone. The control unit 13 receives the signal sent from each cell and concludes about the position of the touch between the two ends of the rectangle, along the axis.

For a better detection of the exact touched control zone, the touch sensing unit 5 is preferably made of a set of separate touch detectors 5a, each corresponding to a separate control zone of the handle 2. Each touch detector 5a sends its own signal to the control unit. As each touch detector 5a is connected to a separate entry of the control unit, the latter directly identifies the control zone which is touched by the user.

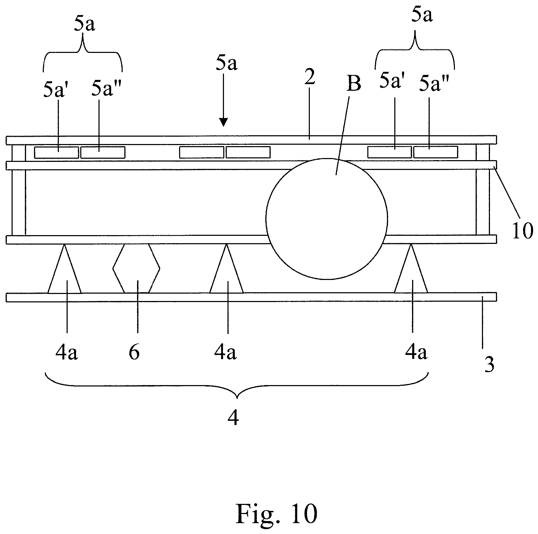

Such a separate touch detector 5a can be based on an optical detection principle, but preferably, a capacitive principle is used. For example, figure 10 shows three touch detectors 5a based on a capacitive principle. Each capacitive based touch detector 5a comprises two capacitive electrodes: an emitter 5a' and a receiver 5a". A finger creates an interference in the magnetic flux between these two electrodes and can thereby be detected as touching the corresponding control zone of the handle 2. The emitter and receiver can be fixed to the handle 2, and moved by it, as will be further described in relation with figure 10, or be fixed to the support 3 on which the handle 2 moves.

The emitter 5a' and the receiver 5a" are preferably made with conductive tracks on a printed circuit board 10, located under the handle 2. In some alternative embodiments, illustrated in figures 2 to 7, the touch sensing unit 5 is made of a set of at least two separate capacitive based touch detectors 5a, each with a single electrode.

In the embodiment shown on figures 2 to 7, the touch detector 5a is based on a capacitive detection principle, using a single electrode. This single electrode has a main flat portion 5b. One end of the electrode is fixed to the printed circuit board 10 and electrically connected in the touch detection circuit.

To reach a good detection quality, the electrode preferably lies directly under the handle 2, close to the external touch surface of said handle 2 (see figure 3). Therefore, the flat portion 5b of the electrode is preferably located directly under the handle 2 in the standard position. The electrode is also flexible enough to let the handle 2 move: the conductive tongue or strip 5c between the upper flat portion 5b and the connection end on the printed circuit board 10 is flexible enough to allow a bending of the electrode when the handle 2 is pushed.

Hence, according to another possible additional feature, a single metallic element forms both the at least one touch detector 5a and the at least one movement detector 4a. For example the single metallic electrode of the at least one touch detector 5a of the movement sensing unit 5 is the movable contact (with the end pad 12') of the at least one conductivity based movement detector 4a.

In fact, it should be noted that, in relation to the embodiment illustrated in figures 5 to 7, the single electrode of the touch detector 5a can also work as the contact bridge 12 of a movement detector 4a. For the movement detection circuit, the signal flows in the capacitive electrode from one end to the other. As a consequence, according to a possible other additional feature, the number of touch detectors 5a and the number of movement detectors 4a are equal, each touch detector 5a having a corresponding movement detector 4a.

Due to the presence of both a touch sensing unit 5 and a movement sensing unit 4, the behaviour of the electrical control device 1 can be different when the handle 2 is touched to when it is moved: sending instructions, lighting up the device, generating confirmations sounds, etc. A first behaviour can be created by the control unit 13 when it receives a signal from the touch sensing unit 5 corresponding to the user touching the handle 2: a light source can be switched on around the touched control zone, a first instruction can be generated by the control unit, an information can be stored in the control unit, etc. A second behaviour can then be created by the control unit 13 when it receives a touch signal and also a signal from the movement sensing unit 4: sending a signal on the network to which the device is connected, generating vibrations, confirmation sound, etc.

The movement of the handle 2 can be interpreted as a confirmation of the wishes of the user, expressed and recognised beforehand through the touch sensing unit 5. For example, the behaviour corresponding to a certain control zone takes place only if the movement of the handle 2 is simultaneously detected: sending an instruction on the network, for example, validating an access code, etc.

In the embodiment of figure 10, the electrical control device 1 has one single movable handle 2. The touch sensing unit 5 is built with three separate capacitive based touch detectors 5a. Each touch detector 5a has a pair of electrodes 5a' and 5a" built as tracks of a printed circuit board 10. Said printed circuit 10 is mounted in the handle 2, and is therefore moved when the handle 2 is pressed by the user. Batteries can also be embedded in the handle 2. The movement sensing unit 4 has three different movement sensing detectors 4a, installed between the structure of the electrical control device 1 and the handle 2 itself. Each movement sensing detector 4a is preferably in the shape of a microswitch 8, connected to a separate entry of the control unit 13. These movement sensing detectors 4a have little and ideally no resistance against the movement of the handle 2. Therefore, they have no interference with the feedback unit 6, as they create no force opposed to the action of the user or able to push the handle back to its normal position.

The feedback unit 6 is made with an additional and separate single element, able to generate a force opposed to the actuation movement of the handle 2 and able to push the handle 2 back to its non actuated position, or at least to help in this reset movement. This single element is located between the handle 2 and the support 3 of the electrical control device 1. Preferably, this element is positioned approximately in the middle of the handle 2, in order to minimize the differences between the mechanical resistances felt by the user in different areas of the handle. The feedback unit 6 can be built by a single microswitch 8, which has the advantage of generating a very well known confirmation feeling for the user.

As shown for this embodiment, for one single handle 2, the movement sensing unit 4, the touch sensing unit 5 and the feedback unit 6, share no common part.

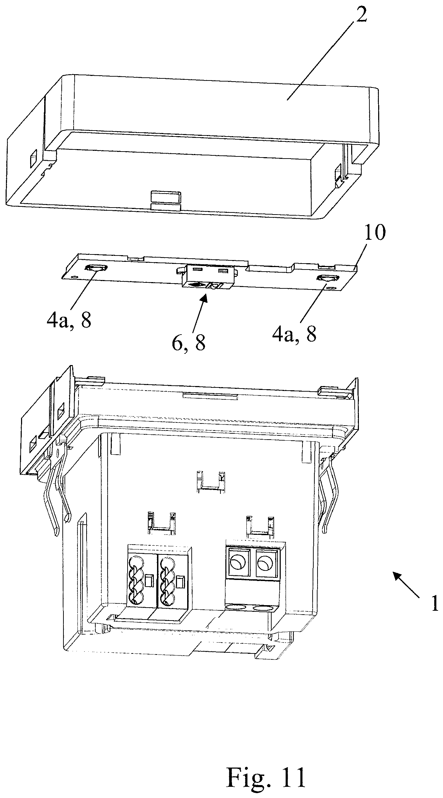

In the embodiment shown on figure 11, the feedback unit 6 and the movement sensing unit 4 share a common part, in the shape of a microswitch 8 which is connected to the control unit 13. In fact, the touch sensing unit 5 has three touch sensing detectors 5a, each made up with two capacitive terminals. The terminals are built as tracks of a printed circuit board 10, linked to the support 3 of the electrical device 1. As seen from figure 11, the printed circuit board 10 covers the complete front surface of the device 1. The movement sensing unit 4 for the handle 2 is built with three separate movement detectors 4a, each separately connected to the control unit. Therefore, the control unit receives three different signals from the movement sensing unit 4. The control unit 13 can use these signals in different ways, and, for example, consider that the handle 2 is in a stable position only if the three signals are equal. It should be noted here that a standard microswitch 8, when connected, can only generate two different signals, one corresponding to its actuated state, with a certain current, one corresponding to its non actuated state, with no current.

These three microswitches 8 can be flexible enough to oppose no force to the movement of the handle 2. Therefore, the feedback and the movement sensing are independently achieved by two different means: the feedback unit 6 and the movement sensing unit 4. According to another possible feature, the feedback can be done by one of the three microswitches 8 which has an increased mechnical resistance. In such embodiments, the movement sensing unit 4 has three movement sensing detectors 4a: two having a very limited or ideally no resistance at all for the the movement of the handle 2, and one having enough mechanical resistance to work as the feedback unit 6. Here, the feedback unit 6 and the movement sensing unit 4 have one common part: a microswitch 8 which is connected to the control unit and which is rigid enough to create a force opposed to the movement of the handle 2. The touch sensing unit 5 share no common part with both the movement sensing unit 4 and the feedback unit 6.

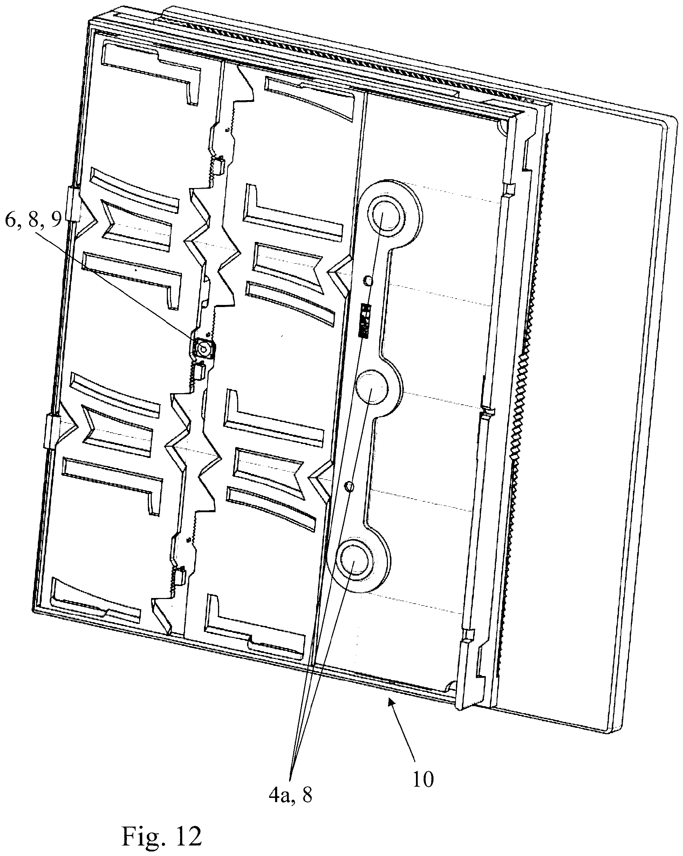

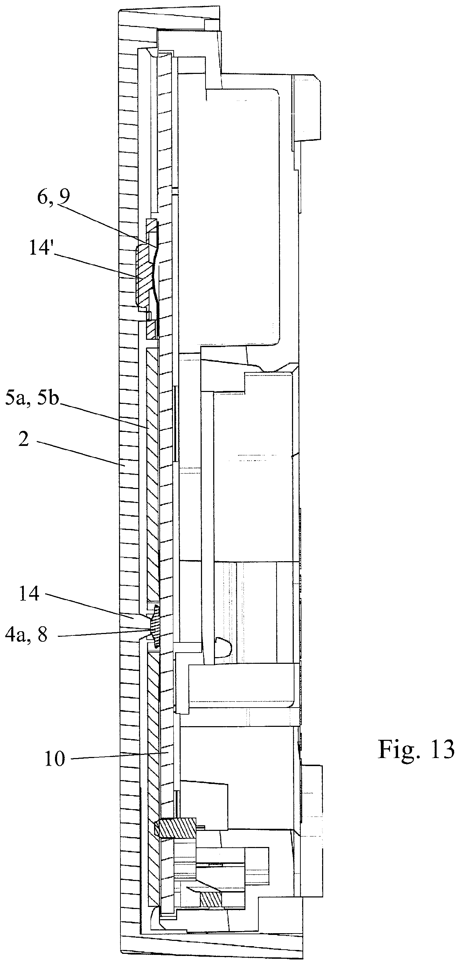

In the embodiment of figures 12 and 13, the electrical control device 1 has six different control zones for a single handle 2. The handle 2 is rotatable along an axis which is perpendicular to the plane of figure 13, in the upper zone thereof. Here again, the touch sensing unit 5 is made with six capacitive cells, each built with two terminals as tracks of the printed circuit board 10, fixed to the support 3. The movement sensing unit 4 is in the form of a rubber mat in which three microswitches 8 are embedded. Each of these three microswitches 8 is connected to the control unit 13 and sends its own signal. This rubber mat is located on the printed circuit board 10 and creates no significant resistance against the movement of the handle 2. The feedback unit 6 is in the form of a single additional component, located between the control zones. This additional component is preferably a microswitch 8, which is not electrically connected to the control unit but only used for its mechanical function. Therefore, here again, there is no common part between the movement sensing unit 4 and the touch sensing unit 5, between the movement sensing unit 4 and the feedback unit 6, and between the feedback unit 6 and the touch sensing unit 5.

While this description described only embodiments in accordance with the present invention, it is understood that the same is not limited thereto but is susceptible of numerous changes and modifications as known to those skilled in the art.

## Claims

1. Electrical control device (1) for mounting to a wall of a domestic electrical installation, configured to generate and send different instruction and/or behavior signals, comprising
- a movable handle, cover or plate (2), moving as a single piece, for the interaction with the user and having a plurality of separate instruction zones;
- a movement sensing unit (4), for detecting the movement and/or position of the handle, cover or plate (2) when it is actuated by the user;
- a touch sensing unit (5), for detecting touches on the handle, cover or plate (2) and the locations thereof;
- a feedback unit (6), for creating a tactile feedback or haptic function when the handle, cover or plate (2) is moved out of its normal or resting position;
- a control unit (13), which is configured to receive input signals from the movement sensing unit (4) as well as input signals from the touch sensing unit (5) and which is configured to generate said instruction and/or behavior signals accordingly,
the touch sensing unit (5) being made of a set of at least two separate touch detectors (5a), each connected to the control unit (13) for sending to the latter a signal corresponding to a touch in a corresponding predefined area of the handle (2),
the movement sensing unit (4) being made of a set of at least two separate movement detectors (4a), each configured to detect the movement of the handle, cover or plate (2),
**characterized in that**
the number of touch detectors (5a) and the number of movement detectors (4a) is equal, each touch detector (5a) being combined or associated with a respectively corresponding movement detector (4a).

2. Electrical control device (1) according to claim 1, **characterised in that**
the feedback unit (6) differs from the set of movement detectors (4a) forming the movement sensing unit (4), and the feedback unit (6) and the set of movement detectors are preferably separate and independent units.

3. Electrical control device (1) according to any of claims 1 or 2, **characterised in that**
the feedback unit (6) comprises at least one mechanical elastic dome (9), preferably in the form of a tactile or snap dome, deformed when the handle, cover or plate (2) is moved by the user and which acts to push the handle, cover or plate (2) back to its normal or resting position.

4. Electrical control device (1) according to any of claims 1 to 3, **characterised in that**
the feedback unit (6) comprises at least one microswitch (8), configured to be actuated when the handle, cover or plate (2) is moved by the user and which acts to push the handle, cover or plate (2) back to its normal or resting position.

5. Electrical control device (1) according to claim 4, **characterised in that**
the at least one microswitch (8) is also configured to be used as one of the movement detectors (4a) of the movement sensing unit (4) and is configured to be connected to the control unit to send a signal when put in its actuated state.

6. Electrical control device (1) according to any of claims 1 or 2, **characterised in that**
the feedback unit (6) is made of at least one force generator generating a force opposed to the movement of the handle, cover or plate (2) out of its normal or resting position.

7. Electrical control device (1) according to any of claims 1 to 6, **characterised in that**
the movement sensing unit (4) is based on a capacitive principle.

8. Electrical control device (1) according to claim 7, **characterised in that**
the movement sensing unit (4) comprises at least one capacitive movement detector (4a) made of a first metallic element mounted in the handle, cover or plate (2) and of a second metallic element mounted on a support (3) of the handle, cover or plate (2).

9. Electrical control device (1) according to any of claims 1 to 8, **characterised in that**
the touch sensing unit (5) is made of a set of at least two separate capacitive based touch detectors (5a), each comprising a pair of metallic electrodes, provided on a printed circuit board (10) located under the handle, cover or plate (2).

10. Electrical control device (1) according to any of claims 1 to 8, **characterised in that**
the touch sensing unit (5) is made of a set of at least two separate capacitive based touch detectors (5a), each with a single electrode.

11. Electrical control device (1) according to any of claims 1 to 6, **characterised in that**
the movement sensing unit (4) comprises at least one conductivity-based movement detector (4a), comprising a movable contact which is configured to be moved by the handle, cover or plate (2) to open or close a corresponding electric circuit.

12. Electrical control device (1) according to claim 10 and to claim 11, **characterised in that**
a single metallic element forms both the at least one touch detector (5a) and the at least one movement detector (4a).

13. Electrical control device (1) according to anyone of claims 11 and 12, **characterised in that**
the at least one conductivity-based movement detector (4a), and preferably each movement detector (4a), is such that its corresponding electrical circuit is open when the handle, cover or plate (2) is not moved by the user.

14. Electrical control device (1) according to any of claims 11 or 12, **characterised in that**
the at least one conductivity-based movement detector (4a), and preferably each movement detector (4a), is such that its corresponding electrical circuit is closed when the handle, cover or plate (2) is not moved by the user.

15. Electrical control device (1) according to any of claims 1 to 14, **characterised in that**
the control unit (13) is made of a single microprocessor.

## Patentansprüche

1. Elektrische Steuervorrichtung (1) zum Montieren an einer Wand einer Hauselektroinstallation, die ausgestaltet ist, unterschiedliche Anweisungs- und/oder Verhaltenssignale zu erzeugen und zu senden, umfassend
- eine(n) bewegliche(n) Griff, Abdeckung oder Platte (2), der bzw. die sich als ein einzelnes Teil bewegt, zur Interaktion mit dem Benutzer und mit einer Mehrzahl von separaten Anweisungszonen;
- eine Bewegungserfassungseinheit (4) zum Detektieren der Bewegung und/oder Position des Griffs, der Abdeckung oder der Platte (2), wenn er bzw. sie durch den Benutzer betätigt wird;
- eine Berührungserfassungseinheit (5) zum Detektieren von Berührungen an dem Griff, der Abdeckung oder der Platte (2) und den Positionen davon;
- eine Rückmeldungseinheit (6) zum Erzeugen einer taktilen Rückmeldung oder haptischen Funktion, wenn der Griff, die Abdeckung oder die Platte (2) aus seiner bzw. ihrer normalen oder Ruheposition bewegt wird;
- eine Steuereinheit (13), die ausgebildet ist, Eingangssignale von der Bewegungserfassungseinheit (4) sowie Eingangssignale von der Berührungserfassungseinheit (5) zu empfangen, und die ausgebildet ist, die Anweisungs- und/oder Verhaltenssignale dementsprechend zu erzeugen,
wobei die Berührungserfassungseinheit (5) aus einem Satz von mindestens zwei separaten Berührungsdetektoren (5a) besteht, die jeweils mit der Steuereinheit (13) zum Senden zu der letzteren eines Signals, das einer Berührung in einem entsprechenden vordefinierten Bereich des Griffs (2) entspricht, verbunden sind,
wobei die Bewegungserfassungseinheit (4) aus einem Satz von mindestens zwei separaten Bewegungsdetektoren (4a) besteht, die jeweils ausgebildet sind, die Bewegung des Griffs, der Abdeckung oder der Platte (2) zu detektieren,
**dadurch gekennzeichnet, dass**
die Anzahl von Berührungsdetektoren (5a) und die Anzahl von Bewegungsdetektoren (4a) gleich ist, wobei jeder Berührungsdetektor (5a) mit einem jeweiligen entsprechenden Bewegungsdetektor (4a) kombiniert oder assoziiert ist.

2. Elektrische Steuervorrichtung (1) nach Anspruch 1, **dadurch gekennzeichnet, dass**
sich die Rückmeldungseinheit (6) von dem Satz von Bewegungsdetektoren (4a), die die Bewegungserfassungseinheit (4) bilden, unterscheidet, und die Rückmeldungseinheit (6) und der Satz von Bewegungsdetektoren vorzugsweise separate und eigenständige Einheiten sind.

3. Elektrische Steuervorrichtung (1) nach einem der Ansprüche 1 oder 2, **dadurch gekennzeichnet, dass**
die Rückmeldungseinheit (6) mindestens eine mechanische elastische Scheibe (9) umfasst, vorzugsweise in der Form einer taktilen oder Schnappscheibe, die verformt wird, wenn der Griff, die Abdeckung oder die Platte (2) durch den Benutzer bewegt wird, und die dazu dient, den Griff, die Abdeckung oder die Platte (2) zurück in seine bzw. ihre normale oder Ruheposition zu drücken.

4. Elektrische Steuervorrichtung (1) nach einem der Ansprüche 1 bis 3, **dadurch gekennzeichnet, dass**
die Rückmeldungseinheit (6) mindestens einen Mikroschalter (8) umfasst, der ausgebildet ist, betätigt zu werden, wenn der Griff, die Abdeckung oder die Platte (2) durch den Benutzer bewegt wird, und der dazu dient, den Griff, die Abdeckung oder die Platte (2) zurück in seine bzw. ihre normale oder Ruheposition zu drücken.

5. Elektrische Steuervorrichtung (1) nach Anspruch 4, **dadurch gekennzeichnet, dass**
der mindestens eine Mikroschalter (8) auch ausgebildet ist, als einer der Bewegungsdetektoren (4a) der Bewegungserfassungseinheit (4) verwendet zu werden, und ausgebildet ist, mit der Steuereinheit verbunden zu sein, um ein Signal zu senden, wenn er in seinen betätigten Zustand versetzt wird.

6. Elektrische Steuervorrichtung (1) nach einem der Ansprüche 1 oder 2, **dadurch gekennzeichnet, dass**
die Rückmeldungseinheit (6) aus mindestens einer Krafterzeugungseinrichtung besteht, die eine Kraft erzeugt, die der Bewegung des Griffs, der Abdeckung oder der Platte (2) aus seiner bzw. ihrer normalen oder Ruheposition entgegengesetzt ist.

7. Elektrische Steuervorrichtung (1) nach einem der Ansprüche 1 bis 6, **dadurch gekennzeichnet, dass**
die Bewegungserfassungseinheit (4) auf einem kapazitiven Prinzip basiert.

8. Elektrische Steuervorrichtung (1) nach Anspruch 7, **dadurch gekennzeichnet, dass**
die Bewegungserfassungseinheit (4) mindestens einen kapazitiven Bewegungsdetektor (4a) umfasst, der aus einem ersten Metallelement, das in dem Griff, der Abdeckung oder der Platte (2) montiert ist, und aus einem zweiten Metallelement, das an einer Halterung (3) des Griffs, der Abdeckung oder der Platte (2) montiert ist, besteht.

9. Elektrische Steuervorrichtung (1) nach einem der Ansprüche 1 bis 8, **dadurch gekennzeichnet, dass**
die Berührungserfassungseinheit (5) aus einem Satz von mindestens zwei separaten kapazitiv-basierten Berührungsdetektoren (5a) besteht, von denen jeder ein Paar von Metallelektroden umfasst, die auf einer Leiterplatte (10) bereitgestellt sind, die sich unter dem Griff, der Abdeckung oder der Platte (2) befindet.

10. Elektrische Steuervorrichtung (1) nach einem der Ansprüche 1 bis 8, **dadurch gekennzeichnet, dass**
die Berührungserfassungseinheit (5) aus einem Satz von mindestens zwei separaten kapazitiv-basierten Berührungsdetektoren (5a) mit jeweils einer einzelnen Elektrode besteht.

11. Elektrische Steuervorrichtung (1) nach einem der Ansprüche 1 bis 6, **dadurch gekennzeichnet, dass**
die Bewegungserfassungseinheit (4) mindestens einen kapazitiv-basierten Bewegungsdetektor (4a) umfasst, der einen beweglichen Kontakt umfasst, der ausgebildet ist, durch den Griff, die Abdeckung oder die Platte (2) bewegt zu werden, um einen entsprechenden elektrischen Schaltkreis zu öffnen oder zu schließen.

12. Elektrische Steuervorrichtung (1) nach Anspruch 10 und nach Anspruch 11, **dadurch gekennzeichnet, dass**
ein einzelnes Metallelement sowohl den mindestens einen Berührungsdetektor (5a) als auch den mindestens einen Bewegungsdetektor (4a) bildet.

13. Elektrische Steuervorrichtung (1) nach einem der Ansprüche 11 und 12, **dadurch gekennzeichnet, dass**
der mindestens eine kapazitiv-basierte Bewegungsdetektor (4a), und vorzugsweise jeder Bewegungsdetektor (4a), derart ist, dass sein entsprechender elektrischer Schaltkreis geöffnet ist, wenn der Griff, die Abdeckung oder die Platte (2) nicht durch den Benutzer bewegt wird.

14. Elektrische Steuervorrichtung (1) nach einem der Ansprüche 11 oder 12, **dadurch gekennzeichnet, dass**
der mindestens eine kapazitiv-basierte Bewegungsdetektor (4a), und vorzugsweise jeder Bewegungsdetektor (4a), derart ist, dass sein entsprechender elektrischer Schaltkreis geschlossen ist, wenn der Griff, die Abdeckung oder die Platte (2) nicht durch den Benutzer bewegt wird.

15. Elektrische Steuervorrichtung (1) nach einem der Ansprüche 1 bis 14, **dadurch gekennzeichnet, dass**
die Steuereinheit (13) aus einem einzelnen Mikroprozessor besteht.

## Revendications

1. Dispositif (1) de commande électrique destiné à être monté sur un mur d'une installation électrique domestique, configuré pour générer et émettre différents signaux d'instructions et/ou de comportement, comportant
- une poignée, un couvercle ou une plaque mobile (2), se déplaçant d'un seul tenant, destinés à l'interaction avec l'utilisateur et présentant une pluralité de zones d'instructions distinctes ;
- une unité (4) de détection de mouvement, destinée à détecter le mouvement et/ou la position de la poignée, du couvercle ou de la plaque (2) lorsqu'ils sont actionnés par l'utilisateur ;
- une unité (5) de détection de toucher, destinée à détecter des touchers sur la poignée, le couvercle ou la plaque (2) et leurs emplacements ;
- une unité (6) de retour, destinée à créer une fonction haptique ou de retour tactile lorsque la poignée, le couvercle ou la plaque (2) sont écartés de leur position normale ou de repos ;
- une unité (13) de commande, qui est configurée pour recevoir des signaux d'entrée provenant de l'unité (4) de détection de mouvement ainsi que des signaux d'entrée provenant de l'unité (5) de détection de toucher et qui est configurée pour générer lesdits signaux d'instructions et/ou de comportement en conséquence,
l'unité (5) de détection de toucher étant constituée d'un ensemble d'au moins deux détecteurs (5a) de toucher distincts, chacun relié à l'unité (13) de commande pour envoyer à cette dernière un signal correspondant à un toucher dans une zone prédéfinie correspondante de la poignée (2),
l'unité (4) de détection de mouvement étant constituée d'un ensemble d'au moins deux détecteurs (4a) de mouvement distincts, chacun configuré pour détecter le mouvement de la poignée, du couvercle ou de la plaque (2),
**caractérisé en ce que**
le nombre de détecteurs (5a) de toucher et le nombre de détecteurs (4a) de mouvement sont égaux, chaque détecteur (5a) de toucher étant combiné avec ou associé à un détecteur (4a) de mouvement respectivement correspondant.

2. Dispositif (1) de commande électrique selon la revendication 1, **caractérisé en ce que**
l'unité (6) de retour diffère de l'ensemble de détecteurs (4a) de mouvement formant l'unité (4) de détection de mouvement, et l'unité (6) de retour et l'ensemble de détecteurs de mouvement sont de préférence des unités distinctes et indépendantes.

3. Dispositif (1) de commande électrique selon l'une quelconque des revendications 1 et 2, **caractérisé en ce que**
l'unité (6) de retour comporte au moins un dôme élastique mécanique (9), de préférence sous la forme d'un dôme tactile ou à déclic, déformé lorsque la poignée, le couvercle ou la plaque (2) sont déplacés par l'utilisateur et qui agit pour ramener la poignée, le couvercle ou la plaque (2) à leur position normale ou de repos.

4. Dispositif (1) de commande électrique selon l'une quelconque des revendications 1 à 3, **caractérisé en ce que**
l'unité (6) de retour comporte au moins un minirupteur (8), configuré pour être actionné lorsque la poignée, le couvercle ou la plaque (2) sont déplacés par l'utilisateur et qui agit pour ramener la poignée, le couvercle ou la plaque (2) à leur position normale ou de repos.

5. Dispositif (1) de commande électrique selon la revendication 4, **caractérisé en ce que**
le ou les minirupteurs (8) sont également configurés pour être utilisés comme un des détecteurs (4a) de mouvement de l'unité (4) de détection de mouvement et sont configurés pour être reliés à l'unité de commande afin d'émettre un signal lorsqu'ils sont placés dans leur état actionné.

6. Dispositif (1) de commande électrique selon l'une quelconque des revendications 1 ou 2, **caractérisé en ce que**
l'unité (6) de retour est constituée d'au moins un générateur de force générant une force opposée au mouvement de la poignée, du couvercle ou de la plaque (2) s'écartant de leur position normale ou de repos.

7. Dispositif (1) de commande électrique selon l'une quelconque des revendications 1 à 6, **caractérisé en ce que**
l'unité (4) de détection de mouvement est basée sur un principe capacitif.

8. Dispositif (1) de commande électrique selon la revendication 7, **caractérisé en ce que**
l'unité (4) de détection de mouvement comporte au moins un détecteur capacitif (4a) de mouvement constitué d'un premier élément métallique monté dans la poignée, le couvercle ou la plaque (2) et d'un second élément métallique monté sur un support (3) de la poignée, du couvercle ou de la plaque (2).

9. Dispositif (1) de commande électrique selon l'une quelconque des revendications 1 à 8, **caractérisé en ce que**
l'unité (5) de détection de toucher est constituée d'un ensemble d'au moins deux détecteurs (5a) de toucher distincts à base capacitive, comportant chacun une paire d'électrodes métalliques, placées sur une carte (10) à circuit imprimé située sous la poignée, le couvercle ou la plaque (2).

10. Dispositif (1) de commande électrique selon l'une quelconque des revendications 1 à 8, **caractérisé en ce que**
l'unité (5) de détection de toucher est constituée d'un ensemble d'au moins deux détecteurs (5a) de toucher distincts à base capacitive, chacun doté d'une seule électrode.

11. Dispositif (1) de commande électrique selon l'une quelconque des revendications 1 à 6, **caractérisé en ce que**
l'unité (4) de détection de mouvement comporte au moins un détecteur (4a) de mouvement basé sur la conductivité, comportant un contact mobile qui est configuré pour être déplacé par la poignée, le couvercle ou la plaque (2) pour ouvrir ou fermer un circuit électrique correspondant.

12. Dispositif (1) de commande électrique selon la revendication 10 et la revendication 11, **caractérisé en ce qu'**un seul élément métallique forme à la fois le ou les détecteurs (5a) de toucher et le ou les détecteurs (4a) de mouvement.

13. Dispositif (1) de commande électrique selon l'une quelconque des revendications 11 et 12, **caractérisé en ce que**
le ou les détecteurs (4a) de mouvement basés sur la conductivité, et de préférence chaque détecteur (4a) de mouvement, est tel que son circuit électrique correspondant est ouvert lorsque la poignée, le couvercle ou la plaque (2) ne sont pas déplacés par l'utilisateur.

14. Dispositif (1) de commande électrique selon l'une quelconque des revendications 11 ou 12, **caractérisé en ce que**
le ou les détecteurs (4a) de mouvement basés sur la conductivité, et de préférence chaque détecteur (4a) de mouvement, est tel que son circuit électrique correspondant est fermé lorsque la poignée, le couvercle ou la plaque (2) ne sont pas déplacés par l'utilisateur.

15. Dispositif (1) de commande électrique selon l'une quelconque des revendications 1 à 14, **caractérisé en ce que**
l'unité (13) de commande est constituée d'un seul microprocesseur.
